# EUROPEAN PATENT SPECIFICATION

(11) **EP 3 714 541 B1**
(45) Date of publication and mention of the grant of the patent: **27.07.2022**
(21) Application number: 18819257.9
(22) Date of filing: 20.11.2018
(51) Int. Cl.: H02P 5/00

(54) **DETERMINING AN ELECTRICAL CURRENT FLOWING IN ONE OF A PLURALITY OF ELECTRIC MOTORS**
BESTIMMUNG EINES ELEKTRISCHEN STROMS, DER IN EINEM VON MEHREREN ELEKTROMOTOREN FLIESST
DÉTERMINATION D'UN COURANT ÉLECTRIQUE CIRCULANT DANS UN MOTEUR ÉLECTRIQUE PARMI UNE PLURALITÉ DE MOTEURS ÉLECTRIQUES

(30) Priority: 20.11.2017 DK PA201700657
(43) Date of publication of application: 30.09.2020
(73) Proprietor: Linak A/S, 6430 Nordborg (DK)
(72) Inventor: BASTHOLM, Jeppe Christian, 6400 Sønderborg (DK)
(74) Representative: Høyer, Michael
(86) International application number: PCT/DK2018/000178
(87) International publication number: WO 2019/096359

(56) References cited:
- EP-A1- 2 051 367
- EP-A1- 3 086 465
- EP-A1- 3 200 340
- WO-A2-2008/080400
- PARK JAEYOUNG ET AL: "Phase current reconstruction with single DC-link current sensor for six-step operation in three phase inverter", 2015 IEEE ENERGY CONVERSION CONGRESS AND EXPOSITION (ECCE), IEEE, 20 September 2015 (2015-09-20), pages 906-912, XP032800673, DOI: 10.1109/ECCE.2015.7309784 [retrieved on 2015-10-27]

## Description

### Technical Field

The invention relates to a method of determining an electrical current flowing in a selected one of a plurality of electric motors connected to and supplied from a power supply and to a system comprising a power supply and a plurality of electric motors connected to and supplied from said power supply. The invention also relates to a computer program and a computer readable medium.

### Background

Electric motors are used in many different applications. As examples, linear actuators, other types of actuators, cooling fans, disk drives, automatic door openers, lifts and traction motors and/or other motors in vehicles (including movable beds and medical carts) can be mentioned. Electric motors can be powered by direct current (DC) sources, such as batteries or rectifiers, or by alternating current (AC) sources, such as the power grid. Typically, the running speed of an electric motor is controlled by a motor controller. An example of a linear actuator with an electric motor is known from WO 2008/080400. Document EP3200340 discloses a power conversion device for controlling a plurality of electric motors comprising phase current detectors for detecting the respective phase currents output from the inverter.

For many types of electric motors (including DC motors and universal motors) and under normal use conditions, the running speed of the motor is proportional to the motor supply voltage, while the delivered mechanical torque or force is proportional to the current drawn from the supply. This means that if the mechanical load of the motor increases, a higher current is drawn from the supply. This higher current provides the additional torque to balance the increased load.

If the motor is overloaded, e.g. because a too heavy load is placed on a hospital bed or a table with adjustable height driven by a linear actuator, or simply because the device driven by the motor is being blocked, the current drawn from the supply may increase to a level that is damaging for the motor. Such damage can be prevented by detecting or measuring the current drawn by the motor and interrupting the supply to the motor if the current exceeds a predetermined maximum value. Alternatively, the supply voltage to the motor can be adjusted by the motor controller in dependence of the measured current.

The current drawn by the motor can be measured by a current measuring device arranged in the connection between the motor and the power supply. The current measuring device can be e.g. an ammeter, a current measuring shunt resistor, a current measuring transformer, a Hall Effect current sensor transducer or a magnetoresistive field current sensor.

In many applications, a plurality of electric motors are connected to and supplied from a common power supply. Also in this situation, a current measuring device can be arranged in the connection between the power supply and the motors so that the current drawn by the motors can be supervised. However in this case, since all motors should be allowed to draw their maximum current simultaneously, the predetermined maximum value needs to be the sum of the individual maximum values, so that the supply voltage to one or more of the motors is interrupted only if the measured current exceeds the sum of the maximum values. However, since some of the motors at a given time may draw little or even no current, another one of the motors could actually draw a current considerably higher than its own predetermined maximum value without the total maximum current value being exceeded. This means that this solution is not sufficient for protecting the individual motors against overload.

A solution could be to arrange a separate current measuring device in the connection to each motor so that their current consumption can be measured individually. However, the use of several current measuring devices means that an increased number of components is needed, which results in an additional cost as well as an increased space requirement in the controller. Further, a separate input terminal on the controller is required for each current measuring device, which is not always available.

### Summary

Therefore, it is an object of embodiments of the invention to provide a simple and cost effective method of determining an electrical current drawn by an individual one of a plurality of electric motors connected to and supplied from a common power supply without the need for the use of a separate current measuring device for each individual motor.

According to embodiments of the invention, the object is achieved in a method of determining an electrical current flowing in a selected one of a plurality of electric motors connected to and supplied from a power supply, wherein a current measuring device is arranged in a connection between the power supply and the plurality of electric motors. The object is achieved when the method comprises the steps of controlling non-selected electric motors to be temporarily disconnected from the power supply; performing a current measurement by said current measuring device while the non-selected electric motors are temporarily disconnected from the power supply, said current measurement being indicative of the electrical current flowing in the selected electric motor; and controlling the non-selected electric motors to be reconnected to the power supply when the current measurement has been performed.

By temporarily disconnecting all electric motors except one from the power supply while a current measurement is performed by the common current measuring device arranged between the power supply and the electric motors, it is achieved that the measured total current equals the current drawn by the motor that is not disconnected. In this way, the current drawn by individual motors can be determined with the use of only one current measuring device, so that additional costs and increased space requirements in the controller for several current measuring devices can be avoided. With the knowledge of the current consumption of individual motors, it is now possible to switch off a motor if its individual maximum current is exceeded due to overload, or the individual motors can be controlled in dependence of their current consumption. The current measured may be a current flowing in the electric motor of a selected one of a plurality of linear actuators, wherein each linear actuator comprises a reversible electric DC motor; a spindle driven by said reversible DC motor; and a spindle nut mounted on the spindle and secured against rotation, said spindle nut being arranged to be moved between two end positions.

In some embodiments, the method comprises the step of driving each of said electric motors by switching at least one electronic switch arranged in series with that electric motor on and off.

The method may comprise the step of temporarily disconnecting non-selected electric motors from the power supply by switching at least one of the at least one electronic switch in series with non-selected electric motors off. By using the electronic switches that are already arranged for driving the electric motors to temporarily disconnect non-selected electric motors from the power supply, there is no need for additional components for this purpose.

In some embodiments, the method comprises the step of driving the electric motors with a pulse width modulated voltage having a variable duty cycle, which is an expedient way of controlling electric motors, especially where several motors are powered from the same power supply. In this case, the method may comprise the step of performing said current measurement in the middle of a pulse of the pulse width modulated voltage driving the selected electric motor. In the middle of the pulse, the current equals the average current of the motor. In some embodiments, the method comprises the step of adjusting the duty cycle of the pulse width modulated voltage driving the selected electric motor in dependence of the measured current indicative of the electrical current flowing in the selected electric motor.

In some embodiments, the method comprises the step of switching off the selected electric motor if the measured current indicative of the electrical current flowing in the selected electric motor exceeds a predetermined maximum value.

As mentioned, the invention also relates to a system comprising a power supply; a plurality of electric motors connected to and supplied from said power supply; a controller; and at least one driver circuit being configured to drive the electric motors under control of the controller. The system further comprises a current measuring device arranged in a connection between the power supply and the plurality of electric motors, and the controller is configured to measure an electrical current flowing in a selected one of the electric motors by controlling non-selected electric motors to be temporarily disconnected from the power supply; performing a current measurement by said current measuring device while the non-selected electric motors are temporarily disconnected from the power supply, said current measurement being indicative of the electrical current flowing in the selected electric motor; and controlling the non-selected electric motors to be reconnected to the power supply when the current measurement has been performed.

When the controller is configured to temporarily disconnect all electric motors except one from the power supply while a current measurement is performed by the common current measuring device arranged between the power supply and the electric motors, it is achieved that the measured total current equals the current drawn by the motor that is not disconnected. In this way, the current drawn by individual motors can be determined with the use of only one current measuring device, so that additional costs and increased space requirements in the controller for several current measuring devices can be avoided. With the knowledge of the current consumption of individual motors, it is now possible to switch off a motor if its individual maximum current is exceeded due to overload, or the individual motors can be controlled in dependence of their current consumption.

The system may be an actuator system comprising a plurality of linear actuators, each linear actuator comprising a reversible electric DC motor; a spindle driven by said reversible DC motor; and a spindle nut mounted on the spindle and secured against rotation, said spindle nut being arranged to be moved between two end positions. The actuator system may further comprise a control box comprising at least the power supply, the controller and the at least one driver circuit; and a plurality of cables, each cable connecting one of the linear actuators to a corresponding driver circuit in the control box. Alternatively, the system may comprise one or more linear actuators in combination with one or more other electric motors connected to and supplied from the same power supply.

In some embodiments, the at least one driver circuit comprises a plurality of electronic switches, wherein each of said electric motors is arranged in series with at least one of said plurality of electronic switches; and the at least one driver circuit is configured to drive each electric motor by switching the at least one electronic switch in series with that electric motor on and off under control of the controller. The plurality of electronic switches may be field effect transistors.

The controller may be configured to temporarily disconnect non-selected electric motors from the power supply by switching at least one of the at least one electronic switch in series with non-selected electric motors off. By using the electronic switches that are already arranged for driving the electric motors to temporarily disconnect non-selected electric motors from the power supply, there is no need for additional components for this purpose.

In some embodiments, the controller is configured to drive the electric motors with a pulse width modulated voltage having a variable duty cycle, which is an expedient way of controlling electric motors, especially where several motors are powered from the same power supply. In this case, the controller may be configured to perform said current measurement in the middle of a pulse of the pulse width modulated voltage driving the selected electric motor. In the middle of the pulse, the current equals the average current of the motor. In some embodiments, the controller is configured to adjust the duty cycle of the pulse width modulated voltage driving the selected electric motor in dependence of the measured current indicative of the electrical current flowing in the selected electric motor.

In some embodiments, the controller is configured to switch off the selected electric motor if the measured current indicative of the electrical current flowing in the selected electric motor exceeds a predetermined maximum value.

The system may comprise a plurality of driver circuits, each driver circuit being configured to drive one of the electric motors under control of the controller, and each driver circuit being implemented as an H bridge driver circuit comprising four electronic switches.

Alternatively, the system may comprise at least one driver circuit comprising six electronic switches arranged in three half bridges, said driver circuit being configured to drive two electric motors under control of the controller.

In some embodiments, said current measuring device may be a current measuring shunt resistor, and the controller may be configured to perform said current measurement by measuring a voltage over said current measuring shunt resistor. This is a simple and cost effective way of measuring the current.

The invention also relates to a computer program comprising program code means for performing the steps of the method described above when said computer program is run on a computer, and to a computer readable medium having stored thereon program code means for performing the method described above when said program code means is run on a computer.

### Brief Description of the Drawings

Embodiments of the invention will now be described more fully below with reference to the drawings, in which
Figure 1 schematically shows an example of a linear actuator,
Figure 2 shows an example of an actuator system, where a linear actuator is controlled by a control box,
Figure 3 shows an electric diagram of a linear actuator connected via a cable to a driver circuit,
Figure 4 shows an example of an actuator system, where three linear actuators are controlled by a control box,
Figure 5 shows a current measuring shunt resistor inserted in series with the actuator of the actuator system of Figure 2,
Figure 6 shows a current measuring shunt resistor inserted in series with the three actuators of the actuator system of Figure 4,
Figure 7 shows a more detailed diagram of a part of the control box of the actuator system of Figure 6 with H bridge driver circuits and with indication of currents when all three motors are active,
Figure 8 shows the waveforms of the currents in the three motors and the total current in the shunt resistor of Figure 7, when the motors are driven with a DC voltage and two motors are temporarily disconnected from the power supply,
Figure 9 shows the diagram of Figure 7 with indication of currents when two motors are temporarily disconnected from the power supply,
Figure 10 shows the waveforms of the currents in the three motors and the total current in the shunt resistor of Figure 7, when the motors are driven with a pulse width modulated voltage and two motors are temporarily disconnected from the power supply,
Figure 11 shows a detailed diagram of a part of a control box of an alternative actuator system where four motors are controlled via two driver circuits and with indication of currents when all four motors are active,
Figure 12 shows the diagram of Figure 11 with indication of currents when three motors are temporarily disconnected from the power supply,
Figure 13 shows a detailed diagram of a motor system with three electric motors and with indication of currents when all three motors are active,
Figure 14 shows the diagram of Figure 13 with indication of currents when two motors are temporarily disconnected from the power supply,
Figure 15 shows an example of an implementation of a voltage measuring device connected across a current measuring shunt resistor,
Figure 16 shows an example where a current measuring shunt resistor is connected directly to a microcomputer in a controller,
Figure 17 shows an example where a current measuring shunt resistor is connected to a microcomputer in a controller via an RC circuit, and
Figure 18 shows a flow chart illustrating a method of determining an electrical current flowing in a selected one of a plurality of electric motors connected to and supplied from a common power supply.

### Detailed Description

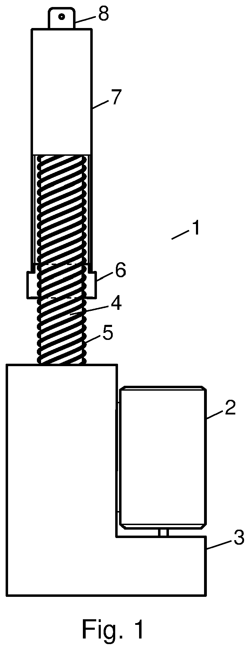

Figure 1 schematically shows an example of a linear actuator 1. The linear actuator 1 comprises a reversible electric motor 2, a transmission or reduction gear 3, typically with several stages, a spindle 4 having a thread 5, a spindle nut 6 engaging the thread 5 and a tube-shaped activation element 7. At the end of the activation element 7, a mounting bracket 8 for mounting the linear actuator 1 to e.g. a carrying element is arranged. The spindle nut 6 is secured against rotation. In some linear actuators, the spindle nut is connected directly to e.g. a carrying element without the use of an activation element. When the spindle 4 is rotated by the motor 2, the spindle nut 6 moves along the spindle 4, thus transforming the rotation to a linear movement of the spindle nut 6 and/or the activation element 7 between two end positions. It is noted that with some motor types, the reversible electric motor 2 can drive the spindle 4 directly, so that the transmission 3 can be avoided. Although other types of electric motors may be used, the reversible electric motor 2 is typically a reversible electric DC motor.

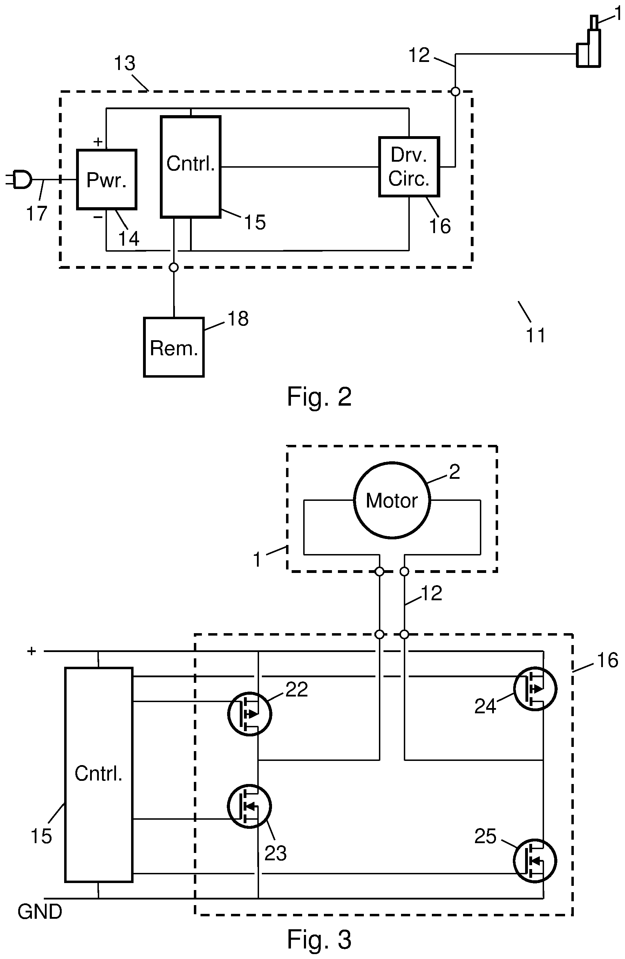

Typically, a linear actuator is used in an actuator system controlled by a control box. An example of such an actuator system 11 is illustrated in Figure 2. Via a cable 12, the linear actuator 1 is connected to a control box 13 that comprises at least a power supply 14, a controller 15 and a driver circuit 16 for the linear actuator 1. The cable 12 between the driver circuit 16 and the linear actuator 1 may have a length of up to two meters or more. The driver circuit 16, and thus also the electric motor 2 of the actuator 1, is controlled by control signals from the controller 15. Typically, the controller 15 comprises a microcomputer. The control box 13 is normally placed on the equipment on which the linear actuator 1 is used. This equipment can represent any one of several different applications, such as trucks, agricultural machinery, industrial automation equipment, hospital and care beds, leisure beds and chairs, tables or other articles of furniture with adjustable height and several other similar applications. The power supply 14 is typically connected to a mains AC supply net with a power cable 17, but a battery may also be used, either alone or in combination with a supply connected to a mains net. Finally, the control box 13 is connected to a remote control 18 allowing the operation of the linear actuator 1 to be controlled by a person in the vicinity of the actuator. The connection between the remote control 18 and the control box 13 may be a wired connection as shown in Figure 2, but a wireless communications system, such as a radio link or an infrared link, may also be used.

The speed of the electric motors of the linear actuator 1 can be controlled by adjusting the DC voltage level supplied to the motor, or it can be controlled by using pulse width modulation (PWM), where the motor speed is instead controlled by adjusting the duty cycle of the pulse width modulation.

The driver circuit 16 can be implemented in different ways. Figure 3 shows a typical example of the driver circuit 16 implemented as an H bridge driver circuit comprising four electronic switches 22, 23, 24 and 25. The driver circuit 16 allows each motor terminal of the motor 2 in the linear actuator 1 to be connected either to a positive supply voltage or to a ground terminal (or negative supply voltage), so that the motor 2 rotates in one direction when electronic switches 22 and 25 are closed, and in the other direction when electronic switches 23 and 24 are closed. The switches 22, 23, 24 and 25 may be any type of electronically controlled switches, such as field effect transistors (FETs), insulated-gate bipolar transistors (IGBTs) or bipolar transistors, and they are switched on and off by the controller 15. In Figure 3, the electronic switches are shown as FETs.

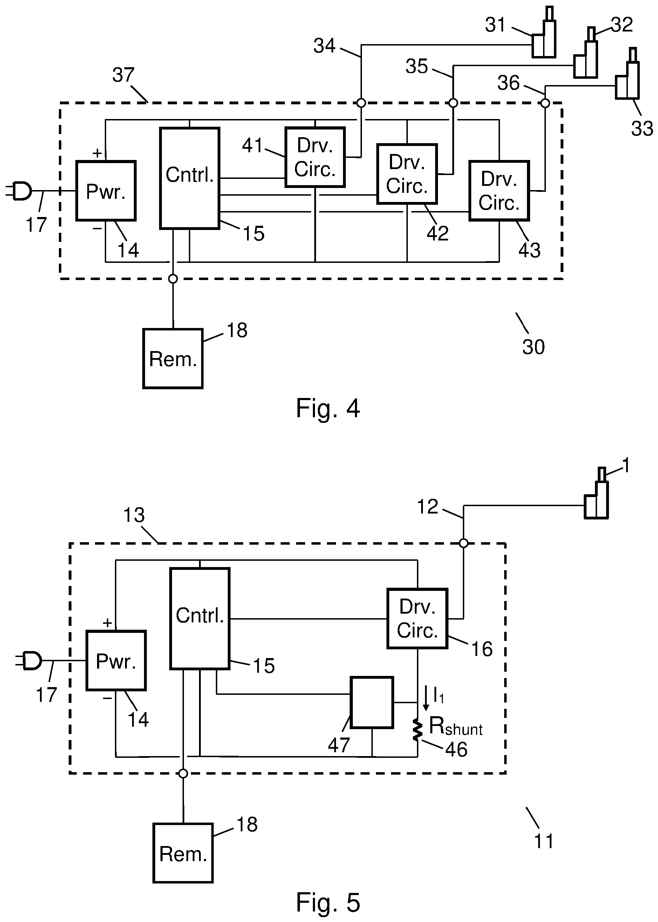

A control box may also be configured to control an actuator system having a plurality of linear actuators. An example of an actuator system 30, where three linear actuators 31, 32 and 33 are used, is illustrated in Figure 4. Via cables 34, 35 and 36 the linear actuators 31, 32 and 33 are connected to a control box 37 that comprises the power supply 14, the controller 15 (as in Figure 2) and a driver circuit for each linear actuator, i.e. driver circuits 41, 42 and 43. Each driver circuit, and thus also the electric motors of the actuators 31, 32 and 33, are controlled individually by control signals from the controller 15, which means that some or all of the actuator motors may be running simultaneously.

In many situations, it is relevant to know the current consumption of linear actuators, or at least to know if this current consumption exceeds a certain limit. As shown in Figure 5, knowledge of the current consumption of the linear actuator 1 in the actuator system 11 of Figure 2 can be obtained by inserting a current measuring shunt resistor 46 having a low and well-defined resistance in series with the actuator 1 and its driver circuit 16. The voltage drop across the shunt 46 is proportional to the current I₁ flowing through it and as its resistance is known, the voltage across the shunt 46 directly indicates the value of current I₁. Thus, a voltage measuring device 47 connected across the shunt resistor 46 can provide information about the current consumption of the linear actuator 1 to the controller 15. The controller 15 can use the measured current value as a feedback signal in the control of the actuator 1. As an example, a maximum current limit can be defined for the actuator 1. If the measured current value exceeds this limit, it is an indication that the motor of the actuator is being overloaded, and the controller 15 can therefore be configured to switch off the motor if the limit is exceeded. The maximum current limit depends on the motor type, but a typical value could be in the range of 5 amperes. Alternatively, the controller 15 can adjust the level of the voltage supplied to the motor in dependence of the measured current value.

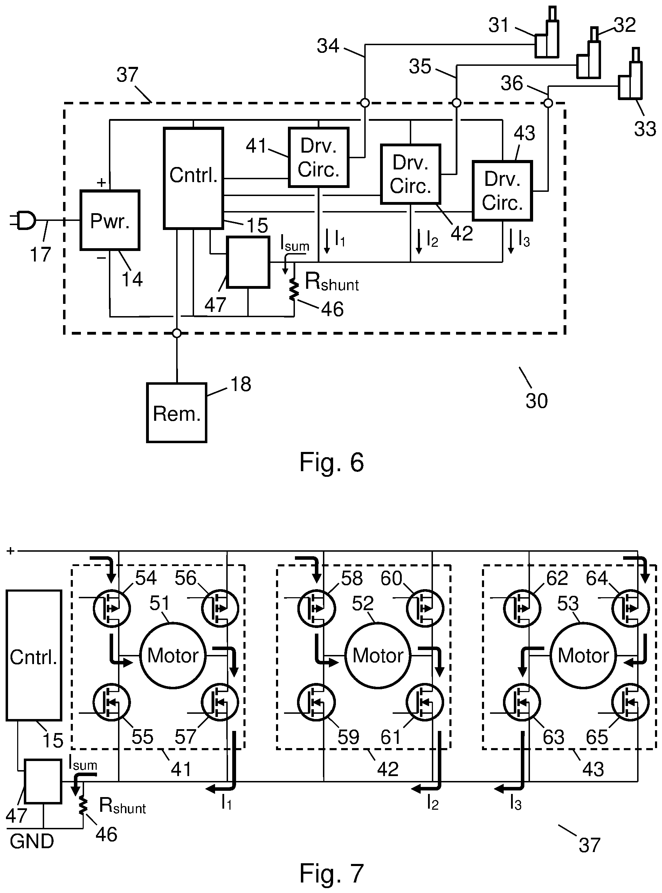

The use of a current measuring shunt resistor for measuring the current consumption of the linear actuators can also be utilized in the actuator system 30 of Figure 4, where a plurality of actuators are connected to the control box. This is illustrated in Figure 6, where a current measuring shunt resistor 46 having a low and well-defined resistance is inserted in series with the actuators 31, 32 and 33 and their driver circuits 41, 42 and 43. Also here, a voltage measuring device 47 connected across the shunt resistor 46 provides information about the current consumption to the controller 15. If the currents delivered by the power supply 19 to each of the driver circuits 41, 42 and 43 and their corresponding linear actuators 31, 32 and 33 are designated as I₁, I₂ and I₃, respectively, the current Iₛᵤₘ through the current measuring shunt 46 is equal to the sum of the currents I₁, I₂ and I₃. Thus, the current measured by the shunt resistor 46 and the voltage measuring device 47 is the total current Iₛᵤₘ consumed by the three driver circuits and their corresponding linear actuators.

However, in some cases, knowledge about the total current consumption is not sufficient. If, as an example, it is assumed that the maximum currents for the linear actuators 31, 32 and 33 are five, four and three amperes, respectively, the maximum current with all three linear actuators being active is 12 amperes, and the controller 15 can be set to indicate (e.g. by giving an alarm or disconnecting the power to the actuators) when and if the measured current Iₛᵤₘ exceeds 12 amperes. However, one or more of the actuators may well use less than their allowed maximum current, and in that case another actuator could exceed its own maximum current considerably before the total limit of 12 amperes is exceeded. Thus, if actuators 31 and 32 only consume one ampere each, e.g. due to a low load, actuator 33 could consume up to 10 amperes before the total limit of 12 amperes is exceeded. This would be more than three times its allowed maximum current, and the motor would probably be damaged although no overload indication has been provided by the current measurement.

In a situation where only two actuators, e.g. actuators 12 and 13, are active, while actuator 14 is inactive, the controller 15 can be set to indicate when and if the measured current Iₛᵤₘ exceeds nine amperes, which is the maximum current for the two actuators. However, if one of the actuators draws less than its allowed maximum current, the other actuator could actually draw more than its allowed maximum current before the limit of nine amperes is exceeded.

This problem could of course be solved by arranging a separate current measuring shunt resistor and corresponding voltage measuring device for each actuator so that their current consumption can be measured individually. However, this means that several additional components are needed and requires the use of additional inputs to the controller, which makes this solution less attractive.

Below, a solution is described that makes it possible to measure the current consumption of the actuators individually with the use of only one single current measuring shunt resistor and corresponding voltage measuring device. Figure 7 shows a more detailed diagram of a part of the control box 37 of the actuator system 30 of Figure 6. Each driver circuit 41, 42 and 43 is implemented as an H bridge driver circuit comprising four electronic switches in the form of FETs, as it was shown in relation to Figure 3. Thus, driver circuit 41 comprises FETs 54, 55, 56 and 57, driver circuit 42 comprises FETs 58, 59, 60 and 61 and driver circuit 43 comprises FETs 62, 63, 64 and 65. The motors 51, 52 and 53 of the linear actuators 31, 32 and 33 are here shown as being a part of the driver circuits for reasons of simplicity, although as mentioned above, they may be arranged externally and connected to the driver circuits via cables. Similarly, for reasons of clarity the connections from the controller 15 to the FETs are not shown.

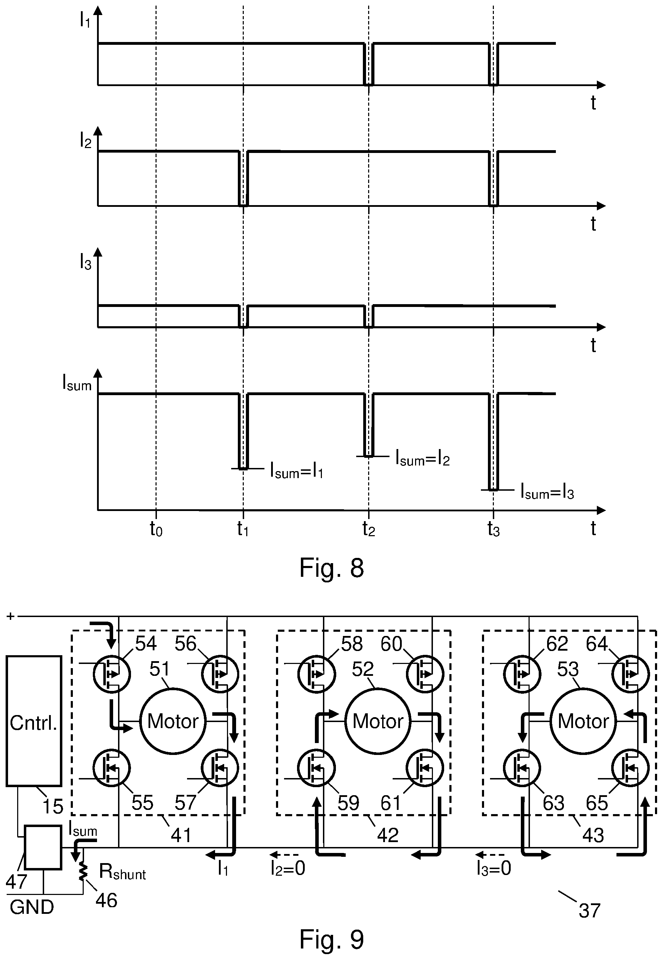

In this example, the motors are driven by a DC voltage level. In driver circuit 41, the voltage is supplied to the motor 51 via FETs 54 and 57 resulting in a motor current I₁ running in the motor. Similarly, the voltage is supplied to the motor 52 in driver circuit 42 via FETs 58 and 61 resulting in a motor current I₂ running in the motor, and in driver circuit 43 the voltage is supplied to the motor 53 via FETs 64 and 63 resulting in a motor current I₃ running in the motor. If the three motors are identical, they will rotate with approximately the same speed, since the same voltage level is supplied to the motors. However, since their load may differ from each other, also the currents I₁, I₂ and I₃ may be different. This is illustrated at time to in Figure 8, which shows the currents I₁, I₂, I₃ and the total current Iₛᵤₘ as a function of time. As it can be seen, the total current Iₛᵤₘ equals I₁ + I₂ + I₃, and thus as mentioned above, the current Iₛᵤₘ measured by the shunt resistor 46 and the voltage measuring device 47 is the total current drawn by all three driver circuits and the corresponding motors in the linear actuators.

In order to determine the current drawn by one of the motors, the controller 15 can be configured to control the two other driver circuits and motors to draw no current from the power supply while a current measurement is performed by the shunt resistor 46 and the voltage measuring device 47. This can be done as illustrated in Figure 9. In the driver circuit 42, FET 58 is switched off and instead FET 59 is switched on. Since FETs 58 and 60 are now both off, motor 52 is disconnected from the power supply and no current is drawn from the power supply by this driver circuit. Due to the inductive character of the motor 52, the current will continue to run in the motor, but this current will now circulate through FETs 59 and 61, so that the current I₂ drawn by driver circuit 42 and motor 52 will be zero. Similarly, in driver circuit 43 FET 64 is switched off and instead FET 65 is switched on, and the motor current will circulate through FETs 63 and 65, so that also the current I₃ drawn by driver circuit 43 and motor 53 will be zero.

It is noted that alternatively, FETs 61 and 63 could be switched off and FETs 60 and 62 switched on, so that the motor currents of motors 52 and 53 would circulate through FETs 58 and 60 and FETs 62 and 64, respectively.

This situation is shown at time t₁ in Figure 8. Shortly before t₁, motors 52 and 53 are disconnected from the power supply as shown in Figure 9 and described above, and since currents I₂ and I₃ are now zero, the total current Iₛᵤₘ will equal the current I₁ drawn by the motor 51 and the driver circuit 41. At time t₁, a current measurement is then performed by the shunt resistor 46 and the voltage measuring device 47, and the measured value of Iₛᵤₘ = I₁ is provided to the controller 15. When the measurement has been performed, the controller 15 restores the situation of Figure 7 by switching FETs 58 and 62 on and FETs 59 and 65 off again. In this way, the current I₁ of one of the three linear actuators has been measured by means of the one single and common current measuring shunt resistor 46.

The disconnection of the motors 52 and 53 from the power supply for a short period of time around t₁ is of course a disturbance of these motors, but since this period of time may be as short as a few microseconds (depending of the implementation of the controller 15), this disturbance is fully acceptable.

At time t₂, the current I₂ drawn by the motor 52 and the driver circuit 42 can be measured in the same way by disconnecting the motors 51 and 53 from the power supply for a short period of time around t₂. This is done by switching FETs 54 and 64 off and FETs 55 and 65 on, so that currents I₁ and I₃ will be zero and the total current Iₛᵤₘ will equal the current I₂ drawn by the motor 52 and the driver circuit 42. Similarly, the current I₃ drawn by the motor 53 and the driver circuit 43 can be measured by disconnecting the motors 51 and 52 from the power supply for a short period of time around t₃.

The time between the current measurements, i.e. the time between t₁ and t₂ and between t₂ and t₃, can be selected according to the needs of the specific actuator system and the specific implementation of the controller 15. For a typical actuator system, a time of 1 millisecond between the measurements could be an appropriate choice. The measurements can of course be repeated, so that for the system described above, current I₁ can again be measured 1 millisecond after the measurement of I₃, and so on. This means that the current of each motor is measured with 3 milliseconds between each measurement.

In the controller 15, the measured values of I₁, I₂ and I₃ that are provided to the controller 15 during the measurements described above can be compared to corresponding maximum current limits that have been predetermined for each of the motors 51, 52 and 53. If the measured current value for one of the motors (i.e. I₁, I₂ or I₃) exceeds the corresponding limit, it is an indication that this motor is being overloaded, and the controller 15 can therefore be configured to switch off the motor if the limit is exceeded. Thus, as an example, motor 52 can be switched off if I₂ exceeds the corresponding limit. This can be done by switching FET 58 off and switching FET 59 on. In this way, an overload of this motor can be avoided.

The described method can also be used when the motors of the linear actuators are driven by an AC voltage instead of a DC voltage as described above. However, in that case it will be expedient to synchronize the measurements with the frequency of the AC voltage, so that for a frequency of 50 Hz, the measurements can be performed with e.g. 20 milliseconds between the measurements to ensure that all measurements are comparable. It is also noted that for AC motors, the driver circuits will be different from the H bridge driver circuits described above.

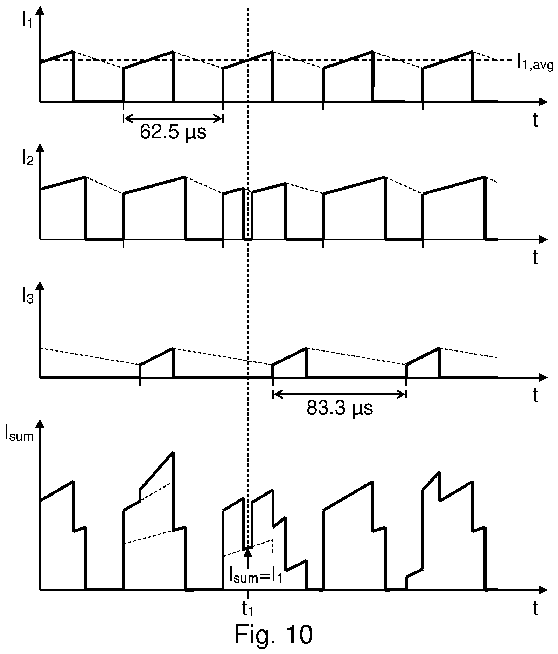

Figure 10 illustrates how the current consumption of one of the three linear actuators in Figures 6, 7 and 9 can be measured by means of the single and common current measuring shunt resistor 46 in the situation where the motors are controlled with a pulse width modulated voltage. Similar to Figure 8, Figure 10 shows the currents I₁, I₂ and I₃ drawn from the power supply by the motors 51, 52 and 53 and the total current Iₛᵤₘ. It is noted that at the time of the current measurement, the motors of the linear actuators may be controlled with different duty cycles and may even have different modulation frequencies. Thus, in Figure 10, the modulation frequency of motors 51 and 52 is chosen to 16 kHz, corresponding to a period of 62.5 µs, while the modulation frequency of motor 53 is chosen to 12 kHz, corresponding to a period of 83.3 µs. The duty cycle of the three motors are shown as 50%, 62.5% and 25%, respectively. During each pulse, a motor draws an increasing current from the power supply. In this context, the current during the pulse can be considered as increasing linearly. During the pauses between the pulses, the current continues to run in the motor due to its inductive character, and as it was shown in Figure 9 for e.g. driver circuit 42, this current circulates through FETs 59 and 61 and is not drawn from the power supply. This current can be considered as decreasing linearly, and it is indicated with a dashed line in Figure 10. For motor 51, the average current I_{1,avg} in the motor is indicated in Figure 10.

Also here, the controller 15 can be configured to determine the current drawn by one of the motors by controlling the two other driver circuits and motors to draw no current from the power supply while a current measurement is performed by the shunt resistor 46 and the voltage measuring device 47. This can be done as it was described in relation to Figure 9. This situation is shown at time t₁ in Figure 10. Shortly before t₁, motors 52 and 53 are controlled to be disconnected from the power supply as it was described above. In this case, one or both of the two other motors may be in a pulse pause around t₁ and thus already disconnected from the power supply. The controller 15 thus just ensures that they stay disconnected until the current measurement has been performed. This is illustrated for motor 53 in Figure 10, where current I₃ is already zero around t₁ due to its pulse pause.

Since currents I₂ and I₃ are now zero, the total current Iₛᵤₘ will equal the current I₁ drawn by the motor 51 and the driver circuit 41. At time t₁, a current measurement is then performed by the shunt resistor 46 and the voltage measuring device 47, and the measured value of Iₛᵤₘ = I₁ is provided to the controller 15. When the measurement has been performed, the controller 15 restores the situation by allowing motors 52 and 53 to draw current from the power supply again according to their pulse modulation. In Figure 10, the pulse for motor 52 that was interrupted is now continued at a slightly lower level, while the pulse pause for motor 53 is continued until the start of the next pulse. In this way, the current I₁ of one of the three linear actuators has been measured by means of the one single and common current measuring shunt resistor 46. It is noted that the time t₁, where the measurement of current I₁ is performed, need to be arranged during a PWM pulse for motor 51. If the measurement was performed during a pulse pause, the current would be zero.

Expediently, the measurement time t₁ for current I₁ can be arranged at the middle of a PWM pulse for motor 51, as it is illustrated in Figure 10, because at this time the measured value of I₁ equals its average value I_{1,avg}, so that the measurement indicates the average current in the motor.

The disconnection of the motors 52 and 53 from the power supply for a short period of time around t₁ is of course a disturbance of the pulse width modulation of these motors, because it can be considered as an additional pulse pause. However, since this period of time may be as short as a few microseconds (depending of the implementation of the controller 15), this disturbance is fully acceptable.

At a time t₂, which is not shown in Figure 10, the current I₂ drawn by the motor 52 and the driver circuit 42 can be measured in the same way by disconnecting the motors 51 and 53 from the power supply for a short period of time around t₂, so that currents I₁ and I₃ will be zero and the total current Iₛᵤₘ will equal the current I₂ drawn by the motor 52 and the driver circuit 42. Similarly, the current I₃ drawn by the motor 53 and the driver circuit 43 can be measured by disconnecting the motors 51 and 52 from the power supply for a short period of time around a time t₃.

Also in a pulse modulated system, the time between the current measurements, i.e. the time between t₁ and t₂ and between t₂ and t₃, can be selected according to the needs of the specific actuator system and the specific implementation of the controller 15. For a typical actuator system, a time of 1 millisecond between the measurements could be an appropriate choice. The measurements can of course be repeated, so that for the system described above, current I₁ can again be measured 1 millisecond after the measurement of I₃, and so on. This means that the current of each motor is measured with 3 milliseconds between each measurement.

In the controller 15, the measured values of I₁, I₂ and I₃ that are provided to the controller 15 during the measurements described above can be used as feedback signals in the control of the motors 51, 52 and 53. Thus, the duty cycle of the pulse width modulated voltage controlling each motor can be adjusted in dependence of the corresponding measured current value according to a control program stored in the controller 15. The measured values of I₁, I₂ and I₃ can also be compared to corresponding maximum current limits that have been predetermined for each of the motors 51, 52 and 53. If the measured current value for one of the motors (i.e. I₁, I₂ or I₃) exceeds the corresponding limit, it is an indication that this motor is being overloaded, and the controller 15 can therefore be configured to reduce the duty cycle or switch off the motor if the limit is exceeded. Thus, as an example, motor 52 can be switched off if I₂ exceeds the corresponding limit. In this way, an overload of this motor can be avoided.

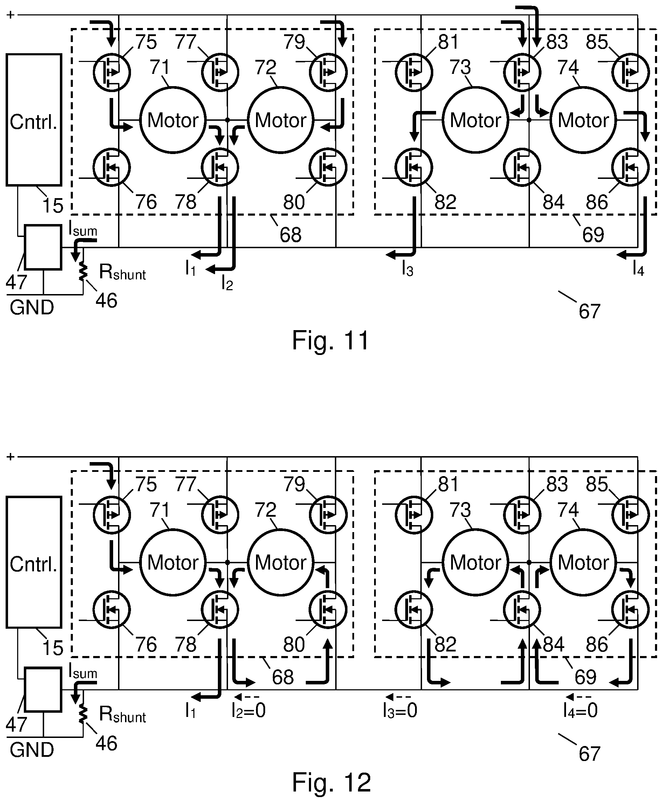

In the examples described above, the controller 15 of the control box 37 is configured to control the motors of three linear actuators 31, 32 and 33 via three driver circuits 41, 42 and 43. However, these numbers are only used as examples. More generally, the described method makes it possible to measure the current consumption of individual motors of a plurality of motors supplied from the same power supply with the use of only one single current measuring shunt resistor and corresponding voltage measuring device. Thus, there could also be only two motors, or there could be four or more motors controlled by the controller. Figures 11 and 12 show an example where four motors are controlled via two driver circuits.

In Figure 11, two motors 71 and 72 are controlled via a driver circuit 68 and two motors 73 and 74 are controlled via a driver circuit 69. Each driver circuit comprises six FETs arranged in three half bridges. Thus, in driver circuit 68, the six FETs 75, 76, 77, 78, 79 and 80 are arranged to drive motors 71 and 72. In this way, two FETs can be saved compared to the driver circuits of Figure 7, where eight FETs would be needed to drive two motors. Of course, this means that there are some restrictions on the direction of rotation of the motors. If e.g. motor 71 is driven through FETs 75 and 78, as shown in Figure 11, FET 77 needs to be off to avoid a short circuit and thus motor 72 can only be driven through FETs 79 and 78. However, in many applications, this is fully acceptable, such as hospital beds or tables with adjustable height where both ends of the bed or the table will normally be either raised or lowered at the same time. Figure 11 illustrates the currents I₁ and I₂ through motors 71 and 72, respectively. Similarly, in driver circuit 69, the six FETs 81, 82, 83, 84, 85 and 86 are arranged to drive motors 73 and 74. Figure 11 also illustrates the currents I₃ and I₄ through motors 73 and 74 driven by FETs 83, 82 and 86.

In order to determine the current drawn by one of the motors, the controller 15 can, as in the examples above, be configured to control the other motors to draw no current from the power supply while a current measurement is performed by the shunt resistor 46 and the voltage measuring device 47. This can be done as illustrated in Figure 12. In the driver circuit 68, FET 79 is switched off and instead FET 80 is switched on. Motor 72 is now disconnected from the power supply and no current is drawn from the power supply by this motor. Due to the inductive character of the motor 72, the current will continue to run in the motor, but this current will now circulate through FETs 78 and 80, so that the current I₂ drawn by motor 72 will be zero. Similarly, in driver circuit 69 FET 83 is switched off and instead FET 84 is switched on, so that the motor current in motor 73 will circulate through FETs 82 and 84 and the motor current in motor 74 will circulate through FETs 86 and 84. Thus, also the currents I₃ and I₄ drawn by motors 73 and 74, respectively, will be zero.

It is noted that in driver circuit 69, as an alternative FETs 82 and 86 could be switched off and FETs 81 and 85 switched on, so that the motor currents of motors 72 and 73 would circulate through FETs 81 and 83 and FETs 85 and 83, respectively.

This situation corresponds to the situation that was shown at time t₁ in Figures 8 and 10, except that there is now also a fourth current I₄. Shortly before t₁, motors 72, 73 and 74 are disconnected from the power supply as shown in Figure 12 and described above, and since currents I₂, I₃ and I₄ are now zero, the total current Iₛᵤₘ will equal the current I₁ drawn by the motor 71 in the driver circuit 68. At time t₁, a current measurement is then performed by the shunt resistor 46 and the voltage measuring device 47, and the measured value of Iₛᵤₘ = I₁ is provided to the controller 15. When the measurement has been performed, the controller 15 restores the situation of Figure 11 by switching FETs 79 and 83 on and FETs 80 and 84 off again. In this way, the current I₁ of one of the four linear actuators has been measured by means of the one single and common current measuring shunt resistor 46.

Also here, the disconnection of the motors 72, 73 and 74 from the power supply for a short period of time around t₁ is of course a disturbance of these motors, but since this period of time may be as short as a few microseconds (depending of the implementation of the controller 15), this disturbance is fully acceptable.

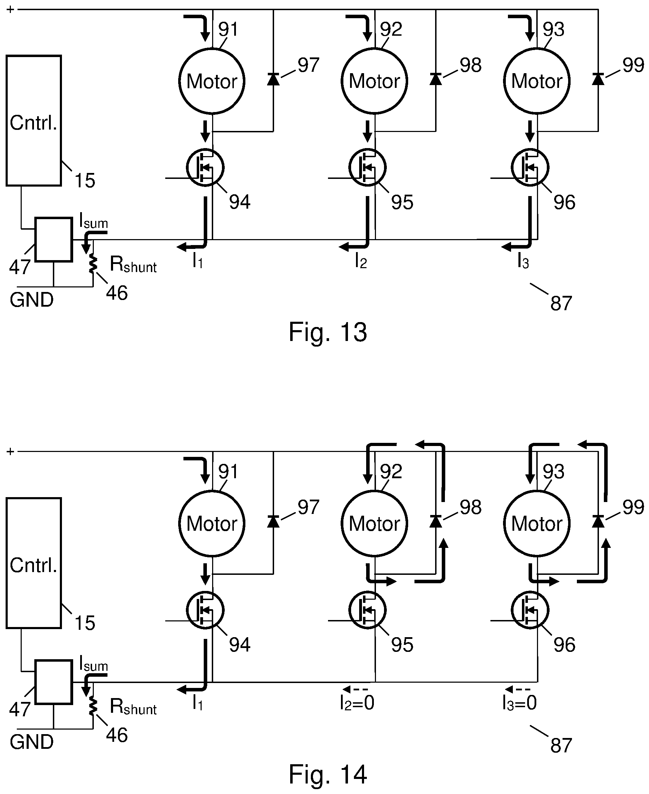

In the examples described above, the electric motors are used in linear actuator systems, where reversible motors are needed. However, in several other systems using electric motors, such as cooling fan systems, it is sufficient that the motors can rotate in one direction, which allows the use of simpler driving circuits. An example of such a system 87 is illustrated in Figures 13 and 14. The method of measuring the current in a selected one of a plurality of electric motors described above can also be used in such systems.

In Figure 13, the controller 15 is arranged to control the three electric motors 91, 92 and 93 via FETs 94, 95 and 96. The currents I₁, I₂ and I₃ through the motors are shown for the situation where all three motors are running. Free-running diodes 97, 98 and 99 ensure that the motor currents can continue to circulate e.g. in pulse pauses of a pulse width modulated system. In Figure 13 the current Iₛᵤₘ through the shunt resistor 46 will be equal to the sum of the three currents I₁, I₂ and I₃.

In order to determine the current drawn by one of the motors in this system, the controller 15 can, as in the examples above, be configured to control the other motors to draw no current from the power supply while a current measurement is performed by the shunt resistor 46 and the voltage measuring device 47. This can be done as illustrated in Figure 14, where FETs 95 and 96 are switched off, so that motors 92 and 93 are disconnected from the power supply and no current is drawn from the power supply by these motors. Due to the inductive character of the motors 92 and 93, the current will continue to run in the motors, but this current will now circulate through the free-running diodes 98 and 99, so that the currents I₂ and I₃ drawn from the power supply will be zero.

This situation corresponds to the situation that was shown at time t₁ in Figures 8 and 10. Shortly before t₁, motors 92 and 96 are disconnected from the power supply as shown in Figure 14 and described above, and since currents I₂ and I₃ are now zero, the total current Iₛᵤₘ will equal the current I₁ drawn by the motor 91. At time t₁, a current measurement is then performed by the shunt resistor 46 and the voltage measuring device 47, and the measured value of Iₛᵤₘ = I₁ is provided to the controller 15. When the measurement has been performed, the controller 15 restores the situation of Figure 13 by switching FETs 95 and 96 on again. In this way, the current I₁ of one of the three motors in e.g. a cooling fan system has been measured by means of the one single and common current measuring shunt resistor 46.

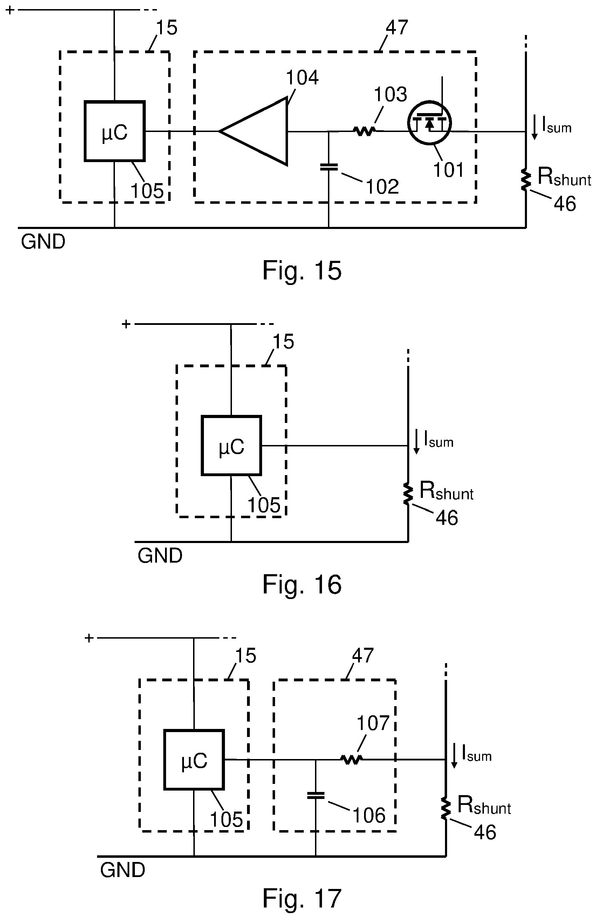

The voltage measuring device 47, which is connected across the shunt resistor 46 and provides information to the controller 15 about the current flowing through the shunt resistor 46, can be implemented in different ways. A traditional implementation is shown in Figure 15, where the voltage across the shunt resistor 46 is sampled by a field effect transistor 101 and provided to a capacitor 102 through a resistor 103. The voltage on the capacitor 102 is then amplified by an amplifier 104 and provided to an input terminal of the microcomputer 105 of the controller 15. In the microcomputer 105, the received signal is then converted from an analog signal to a digital signal in an analog-to-digital converter (not shown) so that it can be processed by the microcomputer 105 and used in the control of the motors as described above.

However, if the resistance of the shunt resistor 46 is chosen appropriately, the voltage across it can be provided directly to the input terminal of the microcomputer 105 as shown in Figure 16. This solution has the advantage that the signal path from the shunt resistor 46 to the input terminal of the microcomputer 105 has a higher bandwidth, which is relevant in order to reduce the short period of time around e.g. t₁, where the other motors are disconnected from the power supply, as it was illustrated in e.g. Figure 10. As mentioned above, this period of time may be as short as a few microseconds. As an example, the resistance of the shunt resistor 46 can be chosen to 40 mΩ.

The analog-to-digital converter at the input terminal of the microcomputer 105 can typically have an overall voltage measurement range (full scale) of 3.3 Volts corresponding to a maximum current in the shunt resistor 46 of 3.3 V / 40 mΩ = 82.5 A, which will be considered as sufficient in this situation. If the analog-to-digital converter has a resolution of 10 bits corresponding to 1024 levels, the voltage resolution will be 3.2 mV corresponding to 80 mA in the shunt resistor 46, and if the analog-to-digital converter has a resolution of 12 bits corresponding to 4096 levels, the voltage resolution will be 0.8 mV corresponding to 20 mA in the shunt resistor 46. This resolution is also considered as being sufficient for the described application.

The bandwidth of the signal path from the shunt resistor 46 to the input terminal of the microcomputer 105 can be further improved. This is due to the fact that there will always be a certain small inductance in series with the shunt resistor 46, which can therefore be considered as an RL circuit composed of a resistor and an inductor. Above the 3dB bandwidth of the RL circuit the impedance will increase, which will thus also be the case for the voltage measured over the shunt resistor 46 for a given current value. It is noted that the 3dB bandwidth is determined by the time constant τ of the RL circuit (f_{3dB} = 1 / 2πτ), which is defined as τ = L / Rₛₕᵤₙₜ, where L is the small inductance in series with the shunt resistor 46.

This can be compensated by adding an RC circuit comprising a capacitor 106 and a resistor 107 as shown in Figure 17. The time constant τ of the RC circuit is defined as τ = R C, where R is the resistance of resistor 107 and C is the capacitance of capacitor 106. If the RC circuit is designed to have the same time constant τ as the RL circuit of the shunt resistor 46, i.e. R C = L / Rₛₕᵤₙₜ, the effect of the inductance in series with the shunt resistor 46 will be compensated, and the bandwidth will be considerably increased.

As an example, the small inductance in series with a shunt resistor of 40 mΩ can be estimated to approximately 40 nH resulting in a time constant τ = 1 µs for the RL circuit. A corresponding time constant τ for the RC circuit can be achieved with e.g. R = 100 Ω and C = 10 nF or R = 1 kΩ and C = 1 nF.

In the examples described above, the current Iₛᵤₘ is measured by means of a current measuring shunt resistor 46 inserted in series with the electric motors. However, it is noted that other techniques of measuring the current can be used as well. A few such techniques are mentioned in the following. As an example, an ammeter can be used, provided it has an output that can provide a signal, which is representative of the measured current, to the controller 15. In some situations, depending on the character of the current to be measured, a current measuring transformer can be used. Also, Hall Effect current sensor transducers can be used. These sensors can sense DC currents and they typically work up to frequencies around 150 kHz. A further sensor type that is well suited for the measurement of electric currents is magnetoresistive field current sensors. Some of these sensor types are available on the market as integrated circuits.

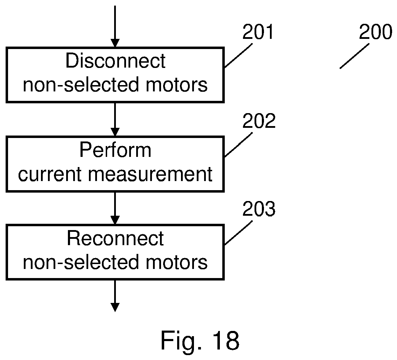

Figure 18 shows a flow chart 200 illustrating a method of determining an electrical current flowing in a selected one of a plurality of electric motors connected to and supplied from a common power supply as described above. In step 201, non-selected electric motors are controlled to be temporarily disconnected from the power supply 14 as it was described in relation to e.g. Figures 9, 12 and 14. In step 202, a current measurement is performed by the current measuring device 46. Since the non-selected electric motors are now temporarily disconnected from the power supply 14, this current measurement is indicative of the electrical current flowing in the selected electric motor, as illustrated in e.g. Figures 9 and 10. Finally, in step 203, the non-selected electric motors are again controlled to be reconnected to the power supply 14 when the current measurement has been performed.

In other words, there is disclosed a method of determining an electrical current flowing in a selected one of a plurality of electric motors connected to and supplied from a power supply, wherein a current measuring device is arranged in a connection between the power supply and the plurality of electric motors. The method comprises the steps of controlling non-selected electric motors to be temporarily disconnected from the power supply; performing a current measurement by said current measuring device while the non-selected electric motors are temporarily disconnected from the power supply, said current measurement being indicative of the electrical current flowing in the selected electric motor; and controlling the non-selected electric motors to be reconnected to the power supply when the current measurement has been performed.

By temporarily disconnecting all electric motors except one from the power supply while a current measurement is performed by the common current measuring device arranged between the power supply and the electric motors, it is achieved that the measured total current equals the current drawn by the motor that is not disconnected. In this way, the current drawn by individual motors can be determined with the use of only one current measuring device, so that additional costs and increased space requirements in the controller for several current measuring devices can be avoided. With the knowledge of the current consumption of individual motors, it is now possible to switch off a motor if its individual maximum current is exceeded due to overload, or the individual motors can be controlled in dependence of their current consumption.

The current measured may be a current flowing in the electric motor of a selected one of a plurality of linear actuators, wherein each linear actuator comprises a reversible electric DC motor; a spindle driven by said reversible DC motor; and a spindle nut mounted on the spindle and secured against rotation, said spindle nut being arranged to be moved between two end positions.

In some embodiments, the method comprises the step of driving each of said electric motors by switching at least one electronic switch arranged in series with that electric motor on and off.

The method may comprise the step of temporarily disconnecting non-selected electric motors from the power supply by switching at least one of the at least one electronic switch in series with non-selected electric motors off. By using the electronic switches that are already arranged for driving the electric motors to temporarily disconnect non-selected electric motors from the power supply, there is no need for additional components for this purpose.

In some embodiments, the method comprises the step of driving the electric motors with a pulse width modulated voltage having a variable duty cycle, which is an expedient way of controlling electric motors, especially where several motors are powered from the same power supply. In this case, the method may comprise the step of performing said current measurement in the middle of a pulse of the pulse width modulated voltage driving the selected electric motor. In the middle of the pulse, the current equals the average current of the motor. In some embodiments, the method comprises the step of adjusting the duty cycle of the pulse width modulated voltage driving the selected electric motor in dependence of the measured current indicative of the electrical current flowing in the selected electric motor.

In some embodiments, the method comprises the step of switching off the selected electric motor if the measured current indicative of the electrical current flowing in the selected electric motor exceeds a predetermined maximum value.

The invention also relates to a system comprising a power supply; a plurality of electric motors connected to and supplied from said power supply; a controller; and at least one driver circuit being configured to drive the electric motors under control of the controller. The system further comprises a current measuring device arranged in a connection between the power supply and the plurality of electric motors, and the controller is configured to measure an electrical current flowing in a selected one of the electric motors by controlling non-selected electric motors to be temporarily disconnected from the power supply; performing a current measurement by said current measuring device while the non-selected electric motors are temporarily disconnected from the power supply, said current measurement being indicative of the electrical current flowing in the selected electric motor; and controlling the non-selected electric motors to be reconnected to the power supply when the current measurement has been performed.

When the controller is configured to temporarily disconnect all electric motors except one from the power supply while a current measurement is performed by the common current measuring device arranged between the power supply and the electric motors, it is achieved that the measured total current equals the current drawn by the motor that is not disconnected. In this way, the current drawn by individual motors can be determined with the use of only one current measuring device, so that additional costs and increased space requirements in the controller for several current measuring devices can be avoided. With the knowledge of the current consumption of individual motors, it is now possible to switch off a motor if its individual maximum current is exceeded due to overload, or the individual motors can be controlled in dependence of their current consumption.

The system may be an actuator system comprising a plurality of linear actuators, each linear actuator comprising a reversible electric DC motor; a spindle driven by said reversible DC motor; and a spindle nut mounted on the spindle and secured against rotation, said spindle nut being arranged to be moved between two end positions. The actuator system may further comprise a control box comprising at least the power supply, the controller and the at least one driver circuit; and a plurality of cables, each cable connecting one of the linear actuators to a corresponding driver circuit in the control box. Alternatively, the system may comprise one or more linear actuators in combination with one or more other electric motors connected to and supplied from the same power supply.

In some embodiments, the at least one driver circuit comprises a plurality of electronic switches, wherein each of said electric motors is arranged in series with at least one of said plurality of electronic switches; and the at least one driver circuit is configured to drive each electric motor by switching the at least one electronic switch in series with that electric motor on and off under control of the controller. The plurality of electronic switches may be field effect transistors.

The controller may be configured to temporarily disconnect non-selected electric motors from the power supply by switching at least one of the at least one electronic switch in series with non-selected electric motors off. By using the electronic switches that are already arranged for driving the electric motors to temporarily disconnect non-selected electric motors from the power supply, there is no need for additional components for this purpose.

In some embodiments, the controller is configured to drive the electric motors with a pulse width modulated voltage having a variable duty cycle, which is an expedient way of controlling electric motors, especially where several motors are powered from the same power supply. In this case, the controller may be configured to perform said current measurement in the middle of a pulse of the pulse width modulated voltage driving the selected electric motor. In the middle of the pulse, the current equals the average current of the motor. In some embodiments, the controller is configured to adjust the duty cycle of the pulse width modulated voltage driving the selected electric motor in dependence of the measured current indicative of the electrical current flowing in the selected electric motor.

In some embodiments, the controller is configured to switch off the selected electric motor if the measured current indicative of the electrical current flowing in the selected electric motor exceeds a predetermined maximum value.

The system may comprise a plurality of driver circuits, each driver circuit being configured to drive one of the electric motors under control of the controller, and each driver circuit being implemented as an H bridge driver circuit comprising four electronic switches.

Alternatively, the system may comprise at least one driver circuit comprising six electronic switches arranged in three half bridges, said driver circuit being configured to drive two electric motors under control of the controller.

In some embodiments, said current measuring device may be a current measuring shunt resistor, and the controller may be configured to perform said current measurement by measuring a voltage over said current measuring shunt resistor. This is a simple and cost effective way of measuring the current.

Also disclosed is a computer program comprising program code means for performing the steps of the method described above when said computer program is run on a computer, and a computer readable medium having stored thereon program code means for performing the method described above when said program code means is run on a computer.

Although various embodiments of the present invention have been described and shown, the invention is not restricted thereto, but may also be embodied in other ways within the scope of the subject-matter defined in the following claims.

## Claims

1. A method of determining an electrical current flowing in a selected one of a plurality of electric motors (51, 52, 53; 71, 72, 73, 74; 91, 92, 93) connected to and supplied from a power supply (14), wherein a current measuring device (46) is arranged in a connection between the power supply (14) and the plurality of electric motors (51, 52, 53; 71, 72, 73, 74; 91, 92, 93),
**characterized in that** the method comprises the steps of:
• controlling non-selected electric motors to be temporarily disconnected from the power supply (14);
• performing a current measurement by said current measuring device (46) while the non-selected electric motors are temporarily disconnected from the power supply (14), said current measurement being indicative of the electrical current flowing in the selected electric motor; and
• controlling the non-selected electric motors to be reconnected to the power supply (14) when the current measurement has been performed.

2. A system (30; 87) comprising:
• a power supply (14);
• a plurality of electric motors (51, 52, 53; 71, 72, 73, 74; 91, 92, 93) connected to and supplied from said power supply (14);
• a controller (15); and
• at least one driver circuit (41, 42, 43; 68, 69; 94, 95, 96) being configured to drive the electric motors (51, 52, 53; 71, 72, 73, 74; 91, 92, 93) under control of the controller (15),
**characterized in that** the system further comprises a current measuring device (46) arranged in a connection between the power supply (14) and the plurality of electric motors (51, 52, 53; 71, 72, 73, 74; 91, 92, 93), and that
the controller (15) is configured to measure an electrical current flowing in a selected one of the electric motors (51, 52, 53; 71, 72, 73, 74; 91, 92, 93) by:
• controlling non-selected electric motors to be temporarily disconnected from the power supply (14);
• performing a current measurement by said current measuring device (46) while the non-selected electric motors are temporarily disconnected from the power supply (14), said current measurement being indicative of the electrical current flowing in the selected electric motor; and
• controlling the non-selected electric motors to be reconnected to the power supply (14) when the current measurement has been performed.

3. A system according to claim 2, **characterized in that** the system is an actuator system (30) comprising a plurality of linear actuators (31, 32, 33), each linear actuator comprising:
• a reversible electric DC motor (2);
• a spindle (4) driven by said reversible DC motor (2); and
• a spindle nut (6) mounted on the spindle (4) and secured against rotation, said spindle nut (6) being arranged to be moved between two end positions.

4. A system according to claim 3, **characterized in that** the actuator system (30) further comprises:
• a control box (37; 67) comprising at least the power supply (14), the controller (15) and the at least one driver circuit (41, 42, 43; 68, 69); and
• a plurality of cables (34, 35, 36), each cable connecting one of the linear actuators (31, 32, 33) to a corresponding driver circuit in the control box (37; 67).

5. A system according to any one of claims 2 to 4, **characterized in that** the at least one driver circuit (41, 42, 43; 68, 69; 94, 95, 96) comprises a plurality of electronic switches, wherein
• each of said electric motors (51, 52, 53; 71, 72, 73, 74; 91, 92, 93) is arranged in series with at least one of said plurality of electronic switches;
• and the at least one driver circuit (41, 42, 43; 68, 69; 94, 95, 96) is configured to drive each electric motor (51, 52, 53; 71, 72, 73, 74; 91, 92, 93) by switching the at least one electronic switch in series with that electric motor on and off under control of the controller (15).

6. A system according to claim 5, **characterized in that** said plurality of electronic switches are field effect transistors.

7. A system according to claim 5 or 6, **characterized in that** the controller (15) is configured to temporarily disconnect non-selected electric motors from the power supply (14) by switching at least one of the at least one electronic switch in series with non-selected electric motors off.

8. A system according to any one of claims 2 to 7, **characterized in that** the controller (15) is configured to drive the electric motors (51, 52, 53; 71, 72, 73, 74; 91, 92, 93) with a pulse width modulated voltage having a variable duty cycle.

9. A system according to claim 8, **characterized in that** the controller (15) is configured to perform said current measurement in the middle of a pulse of the pulse width modulated voltage driving the selected electric motor.

10. A system according to claim 8 or 9, **characterized in that** the controller (15) is configured to adjust the duty cycle of the pulse width modulated voltage driving the selected electric motor in dependence of the measured current indicative of the electrical current flowing in the selected electric motor.

11. A system according to any one of claims 2 to 10, **characterized in that** the controller (15) is configured to switch off the selected electric motor if the measured current indicative of the electrical current flowing in the selected electric motor exceeds a predetermined maximum value.

12. A system according to any one of claims 2 to 11, **characterized in that** the system comprises a plurality of driver circuits (41, 42, 43), each driver circuit being configured to drive one of the electric motors (51, 52, 53) under control of the controller(15), and each driver circuit being implemented as an H bridge driver circuit comprising four electronic switches.

13. A system according to any one of claims 2 to 11, **characterized in that** the system comprises at least one driver circuit (68; 69) comprising six electronic switches arranged in three half bridges, said driver circuit being configured to drive two electric motors (71, 72; 73, 74) under control of the controller (15).

14. A system according to any one of claims 2 to 13, **characterized in that** said current measuring device is a current measuring shunt resistor (46), and that the controller (15) is configured to perform said current measurement by measuring a voltage over said current measuring shunt resistor (46).

15. A computer program comprising program code means for performing the steps of claim 1 when said computer program is run on a computer.

16. A computer readable medium having stored thereon program code means for performing the method of claim 1 when said program code means is run on a computer.

## Patentansprüche

1. Verfahren zum Bestimmen eines elektrischen Stroms, der in einem ausgewählten einer Vielzahl von Elektromotoren (51, 52, 53; 71, 72, 73, 74; 91, 92, 93) fließt, die mit einer Energieversorgung (14) verbunden sind und von dieser versorgt werden, wobei eine Strommesseinrichtung (46) in einer Verbindung zwischen der Energieversorgung (14) und der Mehrzahl von Elektromotoren (51, 52, 53; 71, 72, 73, 74; 91, 92, 93) angeordnet ist, **dadurch gekennzeichnet, dass** das Verfahren die folgenden Schritte aufweist:
• Steuerung nicht ausgewählter Elektromotoren, um sie vorübergehend von der Energieversorgung (14) zu trennen;
• Durchführen einer Strommessung durch die Strommessvorrichtung (46), während die nicht ausgewählten Elektromotoren vorübergehend von der Energieversorgung (14) getrennt sind, wobei die Strommessung den elektrischen Strom anzeigt, der in dem ausgewählten Elektromotor fließt; und
• Steuern, dass die nicht ausgewählten Elektromotoren wieder an die Energieversorgung (14) angeschlossen werden, wenn die Strommessung durchgeführt worden ist.

2. System (30; 87), das aufweist:
• eine Energieversorgung (14);
• eine Vielzahl von Elektromotoren (51, 52, 53; 71, 72, 73, 74; 91, 92, 93), die an die Energieversorgung (14) angeschlossen sind und von dieser versorgt werden;
• eine Steuereinrichtung (15); und
• mindestens eine Treiberschaltung (41, 42, 43; 68, 69; 94, 95, 96), die so konfiguriert ist, dass sie die Elektromotoren (51, 52, 53; 71, 72, 73, 74; 91, 92, 93) unter der Steuereinrichung (15) antreibt,
**dadurch gekennzeichnet, dass** das System ferner eine Strommessvorrichtung (46) aufweist, die in einer Verbindung zwischen der Leistungsversorgung (14) und der Mehrzahl von Elektromotoren (51, 52, 53; 71, 72, 73, 74; 91, 92, 93) angeordnet ist, und dass die Steuereinrichtung (15) so konfiguriert ist, dass sie einen elektrischen Strom misst, der in einem ausgewählten der Elektromotoren (51, 52, 53; 71, 72, 73, 74; 91, 92, 93) fließt, indem sie:
• steuert, dass nicht ausgewählte Elektromotoren vorübergehend von der Stromversorgung (14) getrennt werden;
• eine Strommessung durch die Strommessvorrichtung (46) durchführt, während die nicht ausgewählten Elektromotoren vorübergehend von der Leistungsversorgung (14) getrennt sind, wobei die Strommessung den elektrischen Strom anzeigt, der in dem ausgewählten Elektromotor fließt; und
• steuert, dass die nicht ausgewählten Elektromotoren wieder an die Leistungsversorgung (14) angeschlossen werden, wenn die Strommessung durchgeführt worden ist.

3. System nach Anspruch 2, **dadurch gekennzeichnet, dass** das System ein Aktuatorsystem (30) ist, das eine Vielzahl von linearen Aktuatoren (31, 32, 33) aufweist, wobei jeder lineare Aktuator aufweist:
• einen umsteuerbaren elektrischen Gleichstrommotor (2)
• eine Spindel (4), die von dem umsteuerbaren Gleichstrommotor (2) angetrieben ist; und
• eine Spindelmutter (6), die auf der Spindel (4) montiert und gegen Verdrehen gesichert ist, wobei die Spindelmutter (6) so angeordnet ist, dass sie zwischen zwei Endpositionen bewegt werden kann.

4. System nach Anspruch 3, **dadurch gekennzeichnet, dass** das Aktuatorsystem (30) weiter aufweist:
• eine Steuerbox (37; 67), die zumindest die Leistungsversorgung (14), die Steuereinrichtung (15) und zumindest eine Treiberschaltung (41, 42, 43; 68, 69) aufweist; und
• eine Vielzahl von Kabeln (34, 35, 36), wobei jedes Kabel einen der linearen Aktuatoren (31, 32, 33) mit einer entsprechenden Treiberschaltung in der Steuerbox (37; 67) verbindet.

5. System nach einem der Ansprüche 2 bis 4, **dadurch gekennzeichnet, dass** die mindestens eine Treiberschaltung (41, 42, 43, 68, 69; 94, 95, 96) eine Vielzahl von elektronischen Schaltern aufweist, wobei
• jeder der Elektromotoren (51, 52, 53; 71, 72, 73, 74; 91, 92, 93) in Reihe mit mindestens einer der mehreren elektronischen Schalter angeordnet ist;
• und die mindestens eine Treiberschaltung (41, 42, 43; 68, 69; 94, 95, 96) so ausgelegt ist, dass sie jeden Elektromotor (51, 52, 53; 71, 72, 73, 74; 91, 92, 93) antreibt, indem sie den mindestens einen elektronischen Schalter, der mit diesem Elektromotor in Reihe geschaltet ist, unter Steuerung der Steuereinrichtung (15) ein- und ausschaltet.

6. System nach Anspruch 5, **dadurch gekennzeichnet, dass** die mehreren elektronischen Schalter Feldeffekttransistoren sind.

7. System nach Anspruch 5 oder 6, **dadurch gekennzeichnet, dass** die Steuereinrichtung (15) so konfiguriert ist, dass sie nicht ausgewählte Elektromotoren vorübergehend von der Leistungsversorgung (14) trennt, indem sie mindestens einen der mindestens einen elektronischen Schalter in Reihe mit nicht ausgewählten Elektromotoren ausschaltet.

8. System nach einem der Ansprüche 2 bis 7, **dadurch gekennzeichnet, dass** die Steuereinrichtung (15) so konfiguriert ist, dass sie die Elektromotoren (51, 52, 53; 71, 72, 73, 74; 91, 92, 93) mit einer pulsweiten modulierten Spannung mit variablem Testverhältnis betreibt.

9. System nach Anspruch 8, **dadurch gekennzeichnet, dass** die Steuereinrichtung (15) so konfiguriert ist, dass sie die Strommessung in der Mitte eines Impulses der pulsweiten modulierten Spannung durchführt, die den ausgewählten Elektromotor antreibt.

10. System nach Anspruch 8 oder 9, **dadurch gekennzeichnet, dass** die Steuereinrichtung (15) so konfiguriert ist, dass sie das Tastverhältnis der pulsbreiten modulierten Spannung, die den ausgewählten Elektromotor antreibt, in Abhängigkeit von dem gemessenen Strom, der den in dem ausgewählten Elektromotor fließenden elektrischen Strom anzeigt, einstellt.

11. System nach einem der Ansprüche 2 bis 10, **dadurch gekennzeichnet, dass** die Steuereinrichtung (15) so konfiguriert ist, dass sie den ausgewählten Elektromotor ausschaltet, wenn der gemessene Strom, der den in dem ausgewählten Elektromotor fließenden elektrischen Strom anzeigt, einen vorbestimmten Maximalwert überschreitet.

12. System nach einem der Ansprüche 2 bis 11, **dadurch gekennzeichnet, dass** das System mehrere Treiberschaltungen (41, 42, 43) aufweist, wobei jede Treiberschaltung so konfiguriert ist, dass sie einen der Elektromotoren (51, 52, 53) unter der Steuerung der Steuereinrichtung (15) antreibt und jede Treiberschaltung als eine H-Brücken-Treiberschaltung mit vier elektronischen Schaltern implementiert ist.

13. System nach einem der Ansprüche 2 bis 11, **dadurch gekennzeichnet, dass** das System mindestens eine Treiberschaltung (68; 69) aufweist, die sechs in drei Halbbrücken angeordnete elektronische Schalter aufweist, wobei die Treiberschaltung so konfiguriert ist, dass sie zwei Elektromotoren (71, 72; 73, 74) unter der Steuerung der Steuereinrichtung (15) antreibt.

14. System nach einem der Ansprüche 2 bis 13, **dadurch gekennzeichnet, dass** die Strommessvorrichtung ein Strommess-Nebenschlusswiderstand (46) ist und dass die Steuereinrichtung (15) so konfiguriert ist, dass sie die Strommessung durch Messen einer Spannung über den Strommess-Nebenschlusswiderstand (46) durchführt.

15. Computerprogramm mit Programmcodemitteln zum Durchführen der Schritte nach Anspruch 1, wenn das Programm auf einem Computer ausgeführt wird.

16. Computerlesbares Medium mit darauf gespeicherten Programmcodemitteln zum Ausführen des Verfahrens nach Anspruch 1, wenn die Programmcodemittel auf einem Computer ausgeführt werden.

## Revendications

1. Procédé de détermination d'un courant électrique circulant dans un moteur sélectionné parmi une pluralité de moteurs électriques (51, 52, 53 ; 71, 72, 73, 74 ; 91, 92, 93) connectés à et alimentés par une alimentation électrique (14), dans lequel un dispositif de mesure de courant (46) est disposé dans une connexion entre l'alimentation électrique (14) et la pluralité de moteurs électriques (51, 52, 53 ; 71, 72, 73, 74 ; 91, 92, 93), **caractérisé en ce que** le procédé comprend les étapes consistant à :
• commander des moteurs électriques non sélectionnés pour qu'ils soient temporairement déconnectés de l'alimentation électrique (14) ;
• effectuer une mesure de courant par ledit dispositif de mesure de courant (46) pendant que les moteurs électriques non sélectionnés sont temporairement déconnectés de l'alimentation électrique (14), ladite mesure de courant étant indicative du courant électrique circulant dans le moteur électrique sélectionné ; et
• commander les moteurs électriques non sélectionnés pour qu'ils soient reconnectés à l'alimentation électrique (14) lorsque la mesure de courant a été effectuée.

2. Système (30 ; 87) comprenant :
• une alimentation électrique (14) ;
• une pluralité de moteurs électriques (51, 52, 53 ; 71, 72, 73, 74 ; 91, 92, 93) connectés à et alimentés par ladite alimentation électrique (14) ;
• un dispositif de commande (15) ; et
• au moins un circuit d'entraînement (41, 42, 43 ; 68, 69 ; 94, 95, 96) configuré pour entraîner les moteurs électriques (51, 52, 53 ; 71, 72, 73, 74 ; 91, 92, 93) sous le contrôle du dispositif de commande (15),
**caractérisé en ce que** le système comprend en outre un dispositif de mesure de courant (46) disposé dans une connexion entre l'alimentation électrique (14) et la pluralité de moteurs électriques (51, 52, 53 ; 71, 72, 73, 74 ; 91, 92, 93), et **en ce que** le dispositif de commande (15) est configuré pour mesurer un courant électrique circulant dans un moteur sélectionné parmi les moteurs électriques (51, 52, 53 ; 71, 72, 73, 74 ; 91, 92, 93) en :
• commandant des moteurs électriques non sélectionnés pour qu'ils soient temporairement déconnectés de l'alimentation électrique (14) ;
• effectuant une mesure de courant par ledit dispositif de mesure de courant (46) tandis que les moteurs électriques non sélectionnés sont temporairement déconnectés de l'alimentation électrique (14), ladite mesure de courant étant indicative du courant électrique circulant dans le moteur électrique sélectionné ; et
• commandant les moteurs électriques non sélectionnés pour qu'ils soient reconnectés à l'alimentation électrique (14) lorsque la mesure de courant a été effectuée.

3. Système selon la revendication 2, **caractérisé en ce que** le système est un système d'actionneurs (30) comprenant une pluralité d'actionneurs linéaires (31, 32, 33), chaque actionneur linéaire comprenant :
• un moteur électrique réversible à courant continu (2) ;
• une broche (4) entraînée par ledit moteur à courant continu réversible (2) ; et
• un écrou de broche (6) monté sur la broche (4) et bloqué en rotation, ledit écrou de broche (6) étant agencé pour être déplacé entre deux positions extrêmes.

4. Système selon la revendication 3, **caractérisé en ce que** le système d'actionnement (30) comprend en outre :
• un boîtier de commande (37 ; 67) comprenant au moins l'alimentation électrique (14), le dispositif de commande (15) et ledit au moins un circuit d'entraînement (41, 42, 43 ; 68, 69) ; et
• une pluralité de câbles (34, 35, 36), chaque câble reliant un des actionneurs linéaires (31, 32, 33) à un circuit d'entraînement correspondant dans le boîtier de commande (37 ; 67).

5. Système selon l'une quelconque des revendications 2 à 4, **caractérisé en ce que** ledit au moins un circuit d'entraînement (41, 42, 43, 68, 69 ; 94, 95, 96) comprend une pluralité de commutateurs électroniques, dans lequel
• chacun desdits moteurs électriques (51, 52, 53 ; 71, 72, 73, 74 ; 91, 92, 93) est disposé en série avec au moins un de ladite pluralité de commutateurs électroniques ;
• et ledit au moins un circuit d'entraînement (41, 42, 43 ; 68, 69 ; 94, 95, 96) est configuré pour entraîner chaque moteur électrique (51, 52, 53 ; 71, 72, 73, 74 ; 91, 92, 93) en commutant ledit au moins un commutateur électronique en série avec ce moteur électrique sur et hors tension sous la commande du dispositif de commande (15).

6. Système selon la revendication 5, **caractérisé en ce que** ladite pluralité de commutateurs électroniques sont des transistors à effet de champ.

7. Système selon la revendication 5 ou 6, **caractérisé en ce que** le dispositif de commande (15) est configuré pour déconnecter temporairement les moteurs électriques non sélectionnés de l'alimentation électrique (14) en mettant hors tension au moins un desdits au moins un commutateur électronique en série avec les moteurs électriques non sélectionnés.

8. Système selon l'une quelconque des revendications 2 à 7, **caractérisé en ce que** le dispositif de commande (15) est configuré pour entraîner les moteurs électriques (51, 52, 53 ; 71, 72, 73, 74 ; 91, 92, 93) avec une tension modulée en largeur d'impulsion ayant un rapport cyclique variable.

9. Système selon la revendication 8, **caractérisé en ce que** le dispositif de commande (15) est configuré pour effectuer ladite mesure de courant au milieu d'une impulsion de la tension modulée en largeur d'impulsion entraînant le moteur électrique sélectionné.

10. Système selon la revendication 8 ou 9, **caractérisé en ce que** le dispositif de commande (15) est configuré pour ajuster le rapport cyclique de la tension modulée en largeur d'impulsion pilotant le moteur électrique sélectionné en fonction du courant mesuré indicatif du courant électrique circulant dans le moteur électrique sélectionné.

11. Système selon l'une quelconque des revendications 2 à 10, **caractérisé en ce que** le dispositif de commande (15) est configuré pour éteindre le moteur électrique sélectionné si le courant mesuré indicatif du courant électrique circulant dans le moteur électrique sélectionné dépasse une valeur maximale prédéterminée.

12. Système selon l'une quelconque des revendications 2 à 11, **caractérisé en ce que** le système comprend une pluralité de circuits d'entraînement (41 42, 43), chaque circuit d'entraînement étant configuré pour entraîner un des moteurs électriques (51, 52, 53) sous le contrôle du dispositif de commande (15), et chaque circuit d'entraînement étant implémenté comme un circuit d'entraînement à pont en H comprenant quatre commutateurs électroniques.

13. Système selon l'une quelconque des revendications 2 à 11, **caractérisé en ce que** le système comprend au moins un circuit d'entraînement (68 ; 69) comprenant six commutateurs électroniques disposés en trois demi-ponts, ledit circuit d'entraînement étant configuré pour entraîner deux moteurs électriques (71, 72 ; 73, 74) sous le contrôle du dispositif de commande (15).

14. Système selon l'une quelconque des revendications 2 à 13, **caractérisé en ce que** ledit dispositif de mesure de courant est une résistance en dérivation de mesure de courant (46), et **en ce que** le dispositif de commande (15) est configuré pour effectuer ladite mesure de courant en mesurant une tension sur ladite résistance en dérivation de mesure de courant (46).

15. Programme informatique comprenant des moyens de code de programme pour exécuter les étapes selon la revendication 1 lorsque ledit programme informatique est exécuté sur un ordinateur.

16. Support lisible par ordinateur sur lequel est stocké un moyen de code de programme pour exécuter le procédé selon la revendication 1 lorsque ledit moyen de code de programme est exécuté sur un ordinateur.
